# EUROPÄISCHE PATENTANMELDUNG

(11) **EP 4 554 073 A1**
(43) Veröffentlichungstag der Anmeldung: **14.05.2025**
(21) Anmeldenummer: 23208805.4
(22) Anmeldetag: 09.11.2023
(51) Int. Cl.: H02M 1/32, H02M 7/483, H02H 7/12, H02H 7/16, G01R 31/64

(54) **VERFAHREN ZUR FEHLERERKENNUNG IN EINEM SUBMODULKONDENSATOR EINES MODULAREN MULTILEVEL-STROMRICHTERS**

(71) Anmelder: Innomotics GmbH, 90441 Nürnberg (DE)
(72) Erfinder: Egerer, Patrick, 91785 Ramsberg (DE); Karwatzki, Dennis, 90513 Zirndorf (DE); Baruschka, Lennart, 30900 Wedemark (DE)
(74) Vertreter: Siemens Patent Attorneys

(57) **Zusammenfassung**

Die Erfindung betrifft ein Verfahren zur Fehlererkennung in einem Submodul (1), wobei das Submodul (1) mindestens zwei in Reihe angeordnete Halbleiterschalter (11) und einen zu den zwei in Reihe angeordneten Halbleiterschaltern (11) parallel angeordneten Kondensator (12) aufweist, wobei mittels der Halbleiterschalter (11) an Anschlüssen (13',13") des Submoduls (1) in einem ersten Schaltzustand die Spannung null erzeugbar ist. Zur Verbesserung der Fehlererkennung wird vorgeschlagen, dass eine Spannung (U_{C}) des Kondensators (12) während des ersten Schaltzustands erfasst wird, wobei in Anhängigkeit von einer Änderung der Spannung (U_{C}) des Kondensators (12) ein Fehler des Kondensators (12) erkannt wird. Weiter betrifft die Erfindung ein Submodul (1) für einen modularen Multilevel-Stromrichter (2), wobei das Submodul (1) mindestens zwei in Reihe angeordnete Halbleiterschalter (11) und einen zu den zwei in Reihe angeordneten Halbleiterschaltern (11) parallel angeordneten Kondensator (12) aufweist, wobei mittels der Halbleiterschalter (11) an Anschlüssen (13',13") des Submoduls (1) in einem ersten Schaltzustand die Spannung null erzeugbar ist, wobei das Submodul (1) mit einer Steuereinheit (14) verbunden ist, die dazu eingerichtet ist, ein derartiges Verfahren auszuführen. Die Erfindung betrifft ferner einen modularen Multilevel-Stromrichter (2) mit einer Vielzahl von derartigen Submodulen (1).

## Beschreibung

Die Erfindung betrifft ein Verfahren zur Fehlererkennung in einem Submodul, wobei das Submodul mindestens zwei in Reihe angeordnete Halbleiterschalter und einen zu den zwei in Reihe angeordneten Halbleiterschaltern parallel angeordneten Kondensator aufweist, wobei mittels der Halbleiterschalter an Anschlüssen des Submodule in einem ersten Schaltzustand die Spannung null erzeugbar ist. Ferner betrifft die Erfindung ein Submodul für einen modularen Multilevel-Stromrichter, wobei das Submodul mindestens zwei in Reihe angeordnete Halbleiterschalter und einen zu den zwei in Reihe angeordneten Halbleiterschaltern parallel angeordneten Kondensator aufweist, wobei mittels der Halbleiterschalter an Anschlüssen des Submodule in einem ersten Schaltzustand die Spannung null erzeugbar ist. Die Erfindung betrifft weiter einen modularer Multilevel-Stromrichter mit einer Vielzahl von derartigen Submodulen.

Modularen Multilevel-Stromrichter Topologien weisen eine Vielzahl von in Serie angeordneten Submodulen auf. Das am weitesten verbreitete Beispiel ist der modulare Multilevel-Stromrichter mit Halbbrücken Submodulen. Dabei weist das entsprechende Submodul zwei in Reihe angeordnete Halbleiterschalter auf. Diese in Reihe angeordneten Halbleiterschalter sind parallel zu einem Kondensator angeordnet. Dabei werden die in Reihe angeordneten Halbleiterschalter im Allgemeinen nicht vom gleichen Strom durchflossen. Mit diesem Submodul lassen sich an den Anschlüssen des Submoduls die Spannung null oder die Kondensatorspannung erzeugen. Der Kondensator kann ein einzelner Kondensator sein oder sich aus mehreren Teilkondensatoren zusammensetzen, welche die Wirkung eines einzelnen (Gesamt-)Kondensators haben.

Der Halbleiterschalter weist neben einem schaltenden Element, der einen Strom in eine ersten Stromflussrichtung schalten kann, eine Diode auf, die einen Strom in einer zweiten Stromflussrichtung führt, die zur ersten Stromflussrichtung entgegengesetzt ist. Diese Diode wird auch als Freilaufdiode bezeichnet.

Der Kondensator oder die Teilkondensatoren können beispielsweise als Folienkondensatoren ausgeführt sein. Daneben ist alternativ auch die Verwendung von Elektrolytkondensatoren denkbar. Wenn es zum Ausfall eines solchen Kondensators kommt, ist es vorteilhaft, diesen sicher zu erkennen, um eine entsprechende Fehlerreaktion des Stromrichters einleiten zu können. Dabei kann es sich zum Beispiel um die Abschaltung des Stromrichters oder das Kurzschließen des betroffenen Submoduls mit einem geeigneten Schalter handeln.

Der Erfindung liegt die Aufgabe zugrunde, eine Fehlererkennung des Submoduls hinsichtlich eines Kondensatorfehlers zu verbessern.

Diese Aufgabe durch ein Verfahren zur Fehlererkennung in einem Submodul gelöst, wobei das Submodul mindestens zwei in Reihe angeordnete Halbleiterschalter und einen zu den zwei in Reihe angeordneten Halbleiterschaltern parallel angeordneten Kondensator aufweist, wobei mittels der Halbleiterschalter an Anschlüssen des Submodule in einem ersten Schaltzustand die Spannung null erzeugbar ist, wobei eine Spannung des Kondensators während des ersten Schaltzustands erfasst wird, wobei in Anhängigkeit von einer Änderung der Spannung des Kondensators ein Fehler des Kondensators erkannt wird. Ferner wird diese Aufgabe durch ein Submodul für einen modularen Multilevel-Stromrichter gelöst, wobei das Submodul mindestens zwei in Reihe angeordnete Halbleiterschalter und einen zu den zwei in Reihe angeordneten Halbleiterschaltern parallel angeordneten Kondensator aufweist, wobei mittels der Halbleiterschalter an Anschlüssen des Submodule in einem ersten Schaltzustand die Spannung null erzeugbar ist, wobei das Submodul mit einer Steuereinheit verbunden ist, die dazu eingerichtet ist, ein derartiges Verfahren auszuführen. Diese Aufgabe wird weiter durch einen modularer Multilevel-Stromrichter mit einer Vielzahl von derartigen Submodulen gelöst.

Weitere vorteilhafte Ausgestaltungen der Erfindung sind in den abhängigen Ansprüchen angegeben.

Der Erfindung liegt unter anderem die Erkenntnis zugrunde, dass sich ein Fehler im Kondensator in einem der Submodule dadurch besonders sicher und zuverlässig erkennen lässt, wenn die Spannung des Kondensators, die auch als Spannung über dem Kondensator bezeichnet wird, im ersten Schaltzustand ausgewertet wird. Bei dem ersten Schaltzustand liegt an den Klemmen des Submoduls die Spannung Null an. Das Submodul kann als Submodul für einen modularen Multilevel Stromrichter eingesetzt werden. Die Spannung des Kondensators kann beispielsweise mit einer Messwerteerfassung am Kondensator gemessen und der Steuereinheit zugeführt werden.

Bei dem Submodul ist ein erster der zwei Halbleiterschalter zwischen den Anschlüssen des Submoduls angeordnet, wobei ein zweiter der zwei Halbleiterschalter zwischen einem der Anschlüsse des Submoduls und dem Kondensator angeordnet ist, wobei zur Erzeugung des ersten Schaltzustands beispielsweise der erste Halbleiterschalter derart angesteuert wird, dass er leitend ist und der zweite Halbleiterschalter derart angesteuert wird, dass er sperrend ist. Darüber hinaus ist der erste Schaltzustand auch dadurch erreichbar, wenn keiner der beiden Halbleiterschalter angesteuert wird. Dieser Fall wird auch als Impulssperre des Submoduls bezeichnet, da kein Halbleiterschalter in den leitenden Zustand versetzt wird. In Abhängigkeit von der Stromflussrichtung ist dann eine der Freilaufdioden leitend. In diesem Zustand kann sich der Kondensator aufgrund der Stromflussrichtung nur aufladen und nicht entladen.

Folglich gibt es mehrere Schaltungszustände der Halbleiterschalter, insbesondere einen ersten Schaltungszustand der Halbleiter, bei dem der erste Halbleiterschalter eingeschaltet und der zweite Halbleiter ausgeschaltet ist sowie die Impulssperre, mit denen sich der erste Schaltzustand des Submoduls realisieren lässt. Der erste Schaltzustand ergibt sich dabei dadurch, dass ein erster der zwei Halbleiterschalter zwischen den Anschlüssen des Submoduls angeordnet ist, leitend ist. Dies kann sich dadurch ergeben, dass dieser Halbleiterschalter aktiv per Ansteuerung in den leitenden Zustand versetzt wird oder dass aufgrund der Stromflussrichtung eine zum Schaltelement des Halbleiterschalters antiparallel angeordnete Diode leitend ist.

In diesem ersten Schaltzustand, sind bei fehlerfreiem Submodul die Ströme durch den Kondensator besonders gering. Sie werden nur durch beispielsweise vorhandene Symmetrier- und/oder Entladewiderstände sowie beispielsweise durch die elektrische Versorgung von Hilfsbaugruppen hervorgerufen. Beispiele für Hilfsbaugruppen sind eine Modullogik, eine Ansteuerschaltung oder eine Steuereinheit. Es hat sich gezeigt, dass dieser Strom nahezu unabhängig vom Betriebszustand des Stromrichters ist. Dieser Strom verursacht eine Spannungsänderung über dem Kondensator und kann auf einfache Weise erfasst werden. Mit der Änderung der Spannung des Kondensators kann auf den Strom des Kondensators geschlossen werden. Damit kann ein Fehler des Kondensators zuverlässig erkannt werden, wenn der Strom, hervorgerufen durch einen Fehlerstrom, im ersten Schaltzustand zu groß wird. Dieser Fehler kann zuverlässig über die Änderung der Spannung des Kondensators erkannt werden.

Gegenüber einer Überwachung unabhängig vom Schaltzustand des Submoduls kann die für die Erkennung beobachtbare Änderung der Spannung des Kondensators für das vorgeschlagene Verfahren zur Fehlererkennung besonders klein gewählt werden, da diese Änderung betriebsbedingt auftretende Ströme anderer Schaltzustände nicht berücksichtigen muss, um ein Fehlansprechen zu verhindern. Durch diesen geringen Wert der Änderung wird ein Fehler zuverlässig erkannt und ein längeres Einspeisen eines Stromes in eine Fehlstelle vermieden. Ein derartiges Einspeisen kann auch schon nach einer Dauer von wenigen Netzperioden, also in der Größenordnung von 100ms zu einem Schadensbild wie Brandentwicklung führen. Mit dem vorgeschlagenen Verfahren kann das Risiko eines Brandes deutlich verringert werden. Je nach Auslegung des Grenzwertes für die Erkennung kann ein Brand des Stromrichters aufgrund eines Kondensatorfehlers auch darüber hinaus zuverlässig vermieden werden. Auf entsprechende Branddetektoren kann somit verzichtet werden. Da auch das fehlerhafte Submodul zuverlässig erkannt wird, kann ein aus derartigen Submodule aufgebauter modularer Multilevel-Stromrichter weiterbetrieben werden, wenn das betreffende Submodule, beispielsweise mittels einer geeigneten Kurzschließvorrichtung, deaktiviert wird.

Mit dem vorgeschlagenen Verfahren zur Fehlererkennung sowie mit den vorgeschlagenen Vorrichtungen können Kondensatorfehler sicher und zuverlässig erkannt werden, bei denen es nicht unmittelbar zu einem starken Spannungsabfall kommt, sondern bei denen über einen längeren Zeitraum ein Fehler ansteht, der nur zu einer Spannungsänderung ähnlich wie im Normalbetrieb führt. Alternative Verfahren, die nicht den Schaltzustand des Submoduls berücksichtigen, können derartige Fehler erst erkennen, wenn es zu einer betragsmäßig großen Spannungsänderung (du/dt) der Kondensatorspannung kommt, die eine im Normalbetrieb vorkommende Spannungsänderung übersteigt. Damit wird durch das vorgeschlagene Verfahren das Einspeisen in den fehlerhaften Kondensator für einen längeren Zeitraum verhindert, womit die Folgeschäden, wie beispielsweise einer Brandentwicklung, eines solchen Kondensatorfehler deutlich verringert oder sogar ausgeschlossen werden können.

Die vorgeschlagene Überwachung der Kondensatorspannung verhindert somit zuverlässig die Energieeinspeisung in die Fehlerstelle und begrenzt den Schaden auf den betroffenen Kondensator. Die geringere Energieeinspeisung in die Fehlerstelle verhindert oder senkt zumindest deutlich das Risiko für eine Brandentwicklung.

Die Spannungsüberwachung lässt sich somit auch auf Submodule in Impulssperre, also in einem Schaltungszustand der Halbleiterschalter, bei dem beide Halbleiterschalter ausgeschaltet sind, übertragen. In diesem Fall ist es vorteilhaft, aber nicht zwingend notwendig, die Stromflussrichtung zu berücksichtigten, um den ersten Schaltzustand sicher zu identifizieren. Je nach Vorzeichen des Stroms durch das Submodul ist entweder die Freilaufdiode des ersten Halbleiterschalters oder die Freilaufdiode des zweiten Halbleiterschalters stromführend. Entsprechend kann die Kondensatorspannungsänderung nur wie zuvor beschrieben überwacht werden, wenn die Freilaufdiode des ersten Halbleiterschalters den Strom führt und somit den ersten Schaltzustand des Submoduls realisiert. Andernfalls fließt der Strom über die Submodulkondensatoren und verursacht eine Spannungsänderung. Allerdings handelt es sich bei dieser Spannungsänderung um eine Erhöhung des Kondensatorspannung. Üblicherweise werden alle Zweigströme von modularen Multilevel-Stromrichtern gemessen, womit das Vorzeichen des Stroms durch das Submodul bekannt ist. Ein Zweig bezeichnet hier die Serienschaltung von einem oder mehreren Submodulen mit einer Induktivität. Das vorgeschlagene Verfahren lässt sich auf andere Submodulvarianten als Halbbrückensubmodule, wie beispielsweise Vollbrückenmodule übertragen. Abhängig von deren möglichen Schaltzuständen erfolgt eine Überwachung der Kondensatorspannungen in den Schaltzuständen, in denen ein fehlerfreier Kondensator nur über Selbstentladung, Sperrströme, Entladewiderstände, etc. entladen wird.

Bei einer vorteilhaften Ausgestaltung der Erfindung wird der Fehler dadurch erkannt, dass sich die Spannung des Kondensators um den Wert eines Vielfachen, insbesondere um das Doppelte oder das Dreifache, einer Quantisierungsstufe der Messwerterfassung für die Spannung des Kondensators ändert. Im fehlerfreien Betrieb ist die Spannungsänderung im ersten Schaltzustand in der Regel so gering, dass sie je nach Quantisierung der Spannungsmessung zwischen zwei Schaltvorgängen des Submoduls zu einer nicht bzw. kaum messbaren Spannungsänderung führt. Für den oben beschriebenen länger anstehenden Fehlerfall werden jedoch mindestens zwei Quantisierungsstufen der Spannungserfassung überschritten. Somit kann in einer vorteilhaften Ausgestaltung der Erfindung die Fehlererkennung reagieren, sobald genau zwei Quantisierungsstufen der Spannungserfassung überschritten werden. Damit ist eine besonders schnelle Fehlererkennung realisierbar, ohne eine höhere Genauigkeit bei der Spannungserfassung trotz geringer Spannungsänderungen zu erfordern. In diesem Fall ist folglich die Fehlererkennung nicht nur schnell, sondern auch mit der für den Betrieb ausgelegten Spannungserfassung realisierbar.

Bei einer weiteren vorteilhaften Ausgestaltung der Erfindung wird der Fehler des Kondensators dadurch erkannt, dass die Änderung der Spannung des Kondensators negativ ist und einen vorgebbaren unteren Grenzwert unterschreitet. Da sich der Fehler durch einen Entladestrom des Kondensators äußert, ist im Fehlerfall ein Entladestrom beim Kondensator vorhanden, der zu einer Verringerung der Spannung am Kondensator führt. Es muss daher bei der Strommessung der Messwert nur für eine Stromrichtung ausgewertet werden. Damit ist das Verfahren deutlich einfacher und weniger rechenintensiv durchführbar, da auf nur eine Stromrichtung untersucht werden muss. Gleichzeitig ist dieses Verfahren sowohl für den Schaltungszustand der Halbleiterschalter mit einem eingeschalteten Halbleiterschalter als auch für ein Submodul in Impulssperre durchführbar, ohne den konkreten Schaltungszustand der Halbleiterschalter berücksichtigen zu müssen. Es ist hinreichend, dass das Submodul sich im ersten Schaltzustand befindet.

Grundlage ist dabei die Überwachung der Kondensatorspannung im ersten Schaltzustand. Dabei befindet sich der erste Halbleiterschalter im eingeschalteten Zustand und der zweite Halbleiterschalter im ausgeschalteten Zustand oder das Submodul in Impulssperre. Die Kondensatorspannung bleibt dann bei üblicher Auslegung der Komponenten bis zum nächsten Schaltzustandswechsel nahezu konstant bzw. die Änderung ist gering. Nur über die eventuell vorhandenen Symmetrier- und/oder Entladewiderstände sowie einer Versorgungseinheit für Hilfsbaugruppen, beispielsweise für die Modullogik und IGBT-Ansteuerung, durch den Sperrstrom des ausgeschalteten Schalters/der Freilaufdioden und durch die Selbstentladung des Kondensators bzw. der Kondensatoren kommt es zu einer Entladung des Kondensators.

Die durch den Kondensatorfehler verursachte langsame Entladung führt in diesem ersten Schaltzustand zu einer messbaren Spannungsänderung, die sich deutlich vom Spannungsverlauf im Normalbetrieb bei diesem Schaltzustand unterscheidet. Befindet sich ein Submodul im ersten Schaltzustand, wird der negative Betrag der Spannungsänderung (ΔU) oder der Spannungsänderungsgeschwindigkeit (du/dt) des Kondensators mit dem unteren Grenzwert verglichen. Im Folgenden wird nicht mehr explizit zwischen der Änderung der Spannung und der Änderungsgeschwindigkeit der Spannung unterscheiden. Beide Größen eignen sich für die folgenden Grenzwerte. Ist dieser Wert der Spannungsänderung (ΔU) oder der Spannungsänderungsgeschwindigkeit (du/dt) kleiner, also aufgrund des negativen Vorzeichens betraglich größer, als dieser vorgebbare untere Grenzwert, wird ein Fehler zuverlässig erkannt und eine entsprechende Fehlerreaktion des Stromrichters ausgelöst. Dies kann beispielsweise durch Abschaltung oder Deaktivierung/Brückung des als fehlerhaft erkannten Submoduls erfolgen. Die Höhe des Grenzwerts wird in vorteilhafter Weise abhängig von den verwendeten Kondensatoren und der Stromrichterauslegung gewählt. Wichtig ist, dass nur im ersten Schaltzustand des Submoduls auf diesen unteren Grenzwert, auch als Schwelle bezeichnet, der Spannungsänderung oder der Spannungsänderungsgeschwindigkeit der Spannung über den Kondensator überwacht wird, weil die Spannungsänderung des fehlerhaften Kondensators ähnliche Werte erreicht, wie die Spannungsänderung im Normalbetrieb in einem anderen Schaltzustand. Dies unterscheidet den beschriebenen Überwachungsmechanismus von einer Überwachung, die den Schaltzustand des Submoduls unberücksichtigt lässt und dabei nur auf größere Spannungsänderungen reagieren kann, die deutlich über den im Normalbetrieb auftretenden Spannungsänderungen können. Die Schwelle kann dabei als Spannungsdifferenz (ΔU) oder als Änderungsgeschwindigkeit (du/dt) der Spannung U_{c} ausgebildet sein.

Bei einer weiteren vorteilhaften Ausgestaltung der Erfindung wird der Fehler des Kondensators dadurch erkannt, dass der Betrag der Änderung der Spannung des Kondensators einen vorgebbaren oberen Grenzwert überschreitet. Befindet sich ein Submodul im ersten Schaltzustand, wird der Betrag der Spannungsänderung mit dem oberen Grenzwert verglichen. Ist der Betrag der Spannungsänderung (ΔU) oder der Betrag der Spannungsänderungsgeschwindigkeit (du/dt) größer als dieser vorgebbare obere Grenzwert, wird ein Fehler zuverlässig erkannt und eine entsprechende Fehlerreaktion des Stromrichters ausgelöst. Dies kann auch in dieser Art der Fehlererkennung beispielsweise durch Abschaltung oder Deaktivierung/Brückung des als fehlerhaft erkannten Submoduls erfolgen. Die Höhe des Grenzwerts wird analog in vorteilhafter Weise abhängig von den verwendeten Kondensatoren und der Stromrichterauslegung gewählt. Wichtig ist, dass nur im ersten Schaltzustand, bei dem einer der erste Halbleiterschalter angesteuert wird, des Submoduls auf diesen oberen Grenzwert (obere Schwelle) der Spannungsänderung über den Kondensator überwacht wird. Bei einer Impulssperre kann der Fehler nicht zuverlässig ohne Auswertung der Stromflussrichtung erkannt werden, da auch ein Laden des Kondensators mit einer damit einhergehenden und gewollten Spannungsänderung des Kondensators einhergeht.

Im Folgenden wird die Erfindung anhand der in den Figuren dargestellten Ausführungsbeispiele näher beschreiben und erläutert. Es zeigen:
- FIG 1: den Verlauf der Spannung U_{c} des Kondensators eines fehlerfreien Submoduls,
- FIG 2: den Verlauf der Spannung U_{c} des Kondensators eines fehlerbehafteten Submoduls,
- FIG 3: ein Ausführungsbeispiel eines Submoduls und
- FIG 4: ein Ausführungsbeispiel eines modularen Multilevel-Stromrichters.

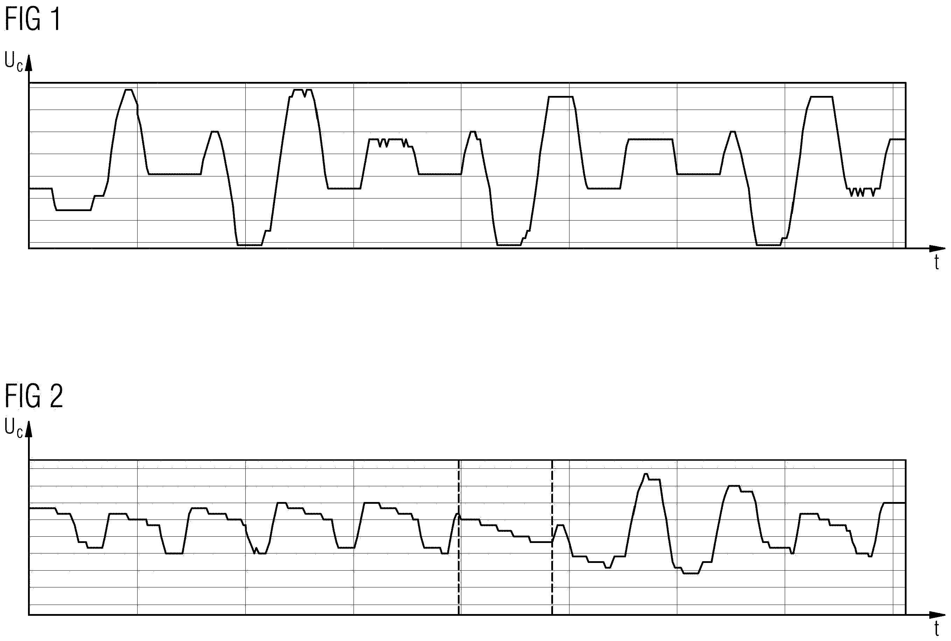

Die FIG 1 zeigt einen typischen Verlauf der Spannung U_{c}, die über dem Kondensator 12 anliegt. Im Betrieb nimmt die Spannung zu oder ab, insbesondere wenn das Submodul 1 in einem Zustand ist, bei dem die Kondensatorspannung an den Anschlüssen 13', 13" des Submoduls 1 anliegt. Befindet sich das Submodul 1 im ersten Schaltzustand, bei dem die Spannung null an den Anschlüssen 13', 13" des Submoduls 1 anliegt, so bleibt die Spannung U_{c} des Kondensators 12 konstant oder zumindest nahezu konstant. Eine Änderung der Spannung wird durch einen Sperrstrom der ausgeschalteten Halbleiterschalter 11, einer Selbstentladung des Kondensators 12 oder durch Widerstände 23, insbesondere durch Dauerentladewiderstände, bewirkt. Diese Spannungsänderung aufgrund des geringen Entladestroms ist während der üblichen Dauer eines Schaltzustands derart gering, dass sie mit der Messwerterfassung 15 teilweise nicht nachweisbar ist. Das liegt daran, dass eine Quantisierungsstufe der Messwerterfassung 15 geringer sein kann als die Spannungsänderung aufgrund des Entladestroms.

Die FIG 2 zeigt ein Beispiel für einen Verlauf der Spannung U_{c}, die über dem Kondensator 12 im Falle eines defekten Submoduls 1, insbesondere eines defekten Kondensators 12 des Submoduls 1, anliegt. Bei dem Defekt, auch als Fehlerfall bezeichnet, handelt es sich beispielsweise um den Verlust von Kapazität des Kondensators 12 oder eine Verringerung des inneren Widerstandes des Kondensators 12. Eine derartige Veränderung des Widerstandes kann sich beispielsweise aus einer Verringerung des Widerstands des Dielektrikums ergeben. Der Entladestrom führt in diesem Fall auch im ersten Schaltzustand zu einer stärkeren Änderung der Spannung U_{c} des Kondensators 12. Diese ist mit der Messwerterfassung 15 des Kondensators 12 messbar, da diese im Fehlerfall größer ist als eine Quantisierungsstufe der Messwerterfassung 15. Diese Spannungsänderung der Spannung U_{c} mit den Quantisierungsstufen der Messwerterfassung 15 ist beispielsweise zwischen den gestrichelten Zeitpunkten aus der genannten Figur ersichtlich. Es ist weiter erkennbar, dass der Kondensatorfehler für einen längeren Zeitraum ansteht und der weiterbetriebene Stromrichter damit Energie in den fehlerhaften Kondensator 12 einspeist. Dabei kann es beispielsweise durch thermische Überlastung zu einer Brandentwicklung innerhalb des Stromrichters ausgehend von dem betroffenen Kondensator 12 kommen. Das vorgeschlagene Verfahren zur Überwachung der Kondensatoren 12 eignet sich zur Fehlerüberwachung insbesondere für einen Stromrichter mit einer Vielzahl von Submodulen 1 und entsprechenden Kondensatoren 12 wie beispielsweise einem modularen Multilevel-Stromrichter 2.

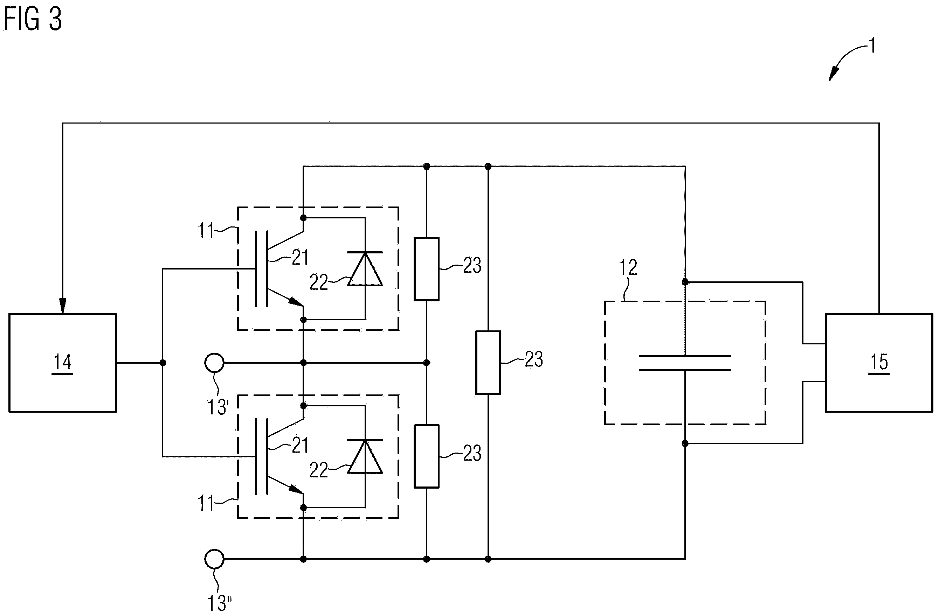

Die FIG 3 zeigt ein Ausführungsbeispiel eines Submoduls 1. Zwischen zwei Anschlüssen 13', 13" des Submoduls 1 ist ein erster von zwei Halbleiterschaltern 11 angeordnet. Ein zweiter der zwei Halbleiterschalter 11 ist zwischen einem der Anschlüsse 13` und dem Kondensator 12 angeordnet. Mit den beiden Halbleiterschaltern 11 lassen sich unterschiedliche Schaltzustände des Submoduls 1 erzielen. Ein erster Schaltzustand, bei dem die Spannung zwischen den Anschlüssen 13', 13" des Submoduls 1 null ist, lässt sich beispielsweise durch Einschalten des ersten der Halbleiterschalter 11 und Ausschalten des zweiten der Halbleiterschalter 11 erreichen. Die Halbleiterschalter 11 werden von einer Steuereinheit 14 angesteuert, der somit sowohl die Schaltungszustände der Halbleiterschalter als auch der Schaltzustand des Submoduls 1 bekannt sind. Eine Messwerterfassung 15 erfasst die Spannung U_{c} über dem Kondensator 12. Dieser Messwert wird der Steuereinheit 14 zugeführt. Mit diesen Informationen kann die Steuereinheit 14 das vorgeschlagene Verfahren ausführen. Darüber hinaus kann die Steuereinheit 14 mittels der Ansteuerung der Halbleiterschalter 11 auf einen erkannten Fehlerfall mit Abschalten der Halbleiterschalter 11 reagieren oder alternativ ein Signal zur Reaktion auf den Fehlerfall zur Übertragung an eine weitere Schutzvorrichtung bereitstellen. Betrieblich vorhandene Entladeströme ergeben sich beispielsweise durch Widerstände 23 im Submodul 1, die für hier nicht näher beschriebene Funktionen vorhanden sind.

Der Halbleiterschalter 11 umfasst jeweils ein schaltendes Element 21 sowie eine Diode 22, die antiparallel zum schaltenden Element 21 angeordnet ist.

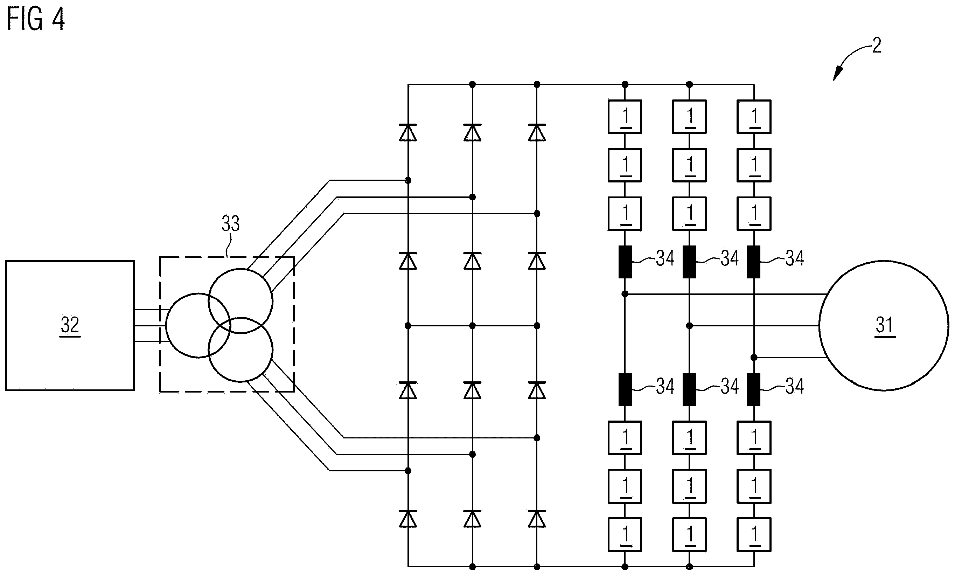

Die FIG 4 zeigt einen modularen Multilevel-Stromrichter 2 mit einer Vielzahl von Submodulen 1, die in dem modularen Multilevel-Stromrichter 2 angeordnet sind. Dieser modularen Multilevel-Stromrichter 2 wird aus einem Energieversorgungsnetz 32 gespeist und die Netzspannung mit Hilfe eines Einspeisetransformators 33 angepasst. Mit Hilfe beispielsweise einer Diodenbrücke wird die Wechselspannung des Energieversorgungsnetzes 32 in eine Gleichspannung gewandelt. Die Submodule 1 des modularen Multilevel-Stromrichter 2 erzeugen aus dieser Gleichspannung eine Wechselspannung zum Betreiben eines Motors 31. Zur Steuerung oder Regelung des Motors 31 wird die durch die Submodule 1 erzeugte Wechselspannung für den Motor 31 durch den modularen Multilevel-Stromrichter 2 in der Amplitude und Frequenz angepasst. Durch die dargestellten Induktivitäten 34 lässt sich das Steuerverhalten und/oder Regelverhalten des modularen Multilevel-Stromrichters 2 verbessern.

Anstelle der Dioden zur Erzeugung der Gleichspannung können alternativ ebenfalls Submodule 1, insbesondere Reihenschaltungen von Submodulen 1 zum Einsatz kommen.

## Patentansprüche

1. Verfahren zur Fehlererkennung in einem Submodul (1), wobei das Submodul (1) mindestens zwei in Reihe angeordnete Halbleiterschalter (11) und einen zu den zwei in Reihe angeordneten Halbleiterschaltern (11) parallel angeordneten Kondensator (12) aufweist, wobei mittels der Halbleiterschalter (11) an Anschlüssen (13',13") des Submoduls (1) in einem ersten Schaltzustand die Spannung null erzeugbar ist, wobei eine Spannung (U_{c}) des Kondensators (12) während des ersten Schaltzustands erfasst wird, wobei in Anhängigkeit von einer Änderung der Spannung (U_{c}) des Kondensators (12) ein Fehler des Kondensators (12) erkannt wird.

2. Verfahren nach Anspruch 1, wobei der Fehler des Kondensators (12) dadurch erkannt wird, dass sich die Spannung (U_{c}) des Kondensators (12) um den Wert eines Vielfachen, insbesondere um das Doppelte oder das Dreifache, einer Quantisierungsstufe einer Messwerterfassung (15) für die Spannung (U_{c}) des Kondensators (12) ändert.

3. Verfahren nach einem der Ansprüche 1 oder 2, wobei der Fehler des Kondensators (12) dadurch erkannt wird, dass die Änderung der Spannung (U_{c}) des Kondensators (12) negativ ist und einen vorgebbaren unteren Grenzwert unterschreitet.

4. Verfahren nach einem der Ansprüche 1 bis 3, wobei der Fehler des Kondensators (12) dadurch erkannt wird, dass der Betrag der Änderung der Spannung (U_{c}) des Kondensators (12) einen vorgebbaren oberen Grenzwert überschreitet.

5. Submodul (1) für einen modularen Multilevel-Stromrichter (2), wobei das Submodul (1) mindestens zwei in Reihe angeordnete Halbleiterschalter (11) und einen zu den zwei in Reihe angeordneten Halbleiterschaltern (11) parallel angeordneten Kondensator (12) aufweist, wobei mittels der Halbleiterschalter (11) an Anschlüssen (13',13") des Submoduls (1) in einem ersten Schaltzustand die Spannung null erzeugbar ist, wobei das Submodul (1) mit einer Steuereinheit (14) verbunden ist, die dazu eingerichtet ist, ein Verfahren nach einem der Ansprüche 1 bis 4 auszuführen.

6. Modularer Multilevel-Stromrichter (2) mit einer Vielzahl von Submodulen (1) nach Anspruch 5.
